# EUROPÄISCHE PATENTSCHRIFT

(11) **EP 0 883 332 B1**
(45) Veröffentlichungstag und Bekanntmachung des Hinweises auf die Patenterteilung: **22.09.2004**
(21) Anmeldenummer: 98105370.5
(22) Anmeldetag: 25.03.1998
(51) Int. Cl.: H05K 7/20, H05K 3/34

(54) **Steuergerät**
Control device
Dispositif de commande

(30) Priorität: 04.06.1997 DE 19723409
(43) Veröffentlichungstag der Anmeldung: 09.12.1998
(73) Patentinhaber: ROBERT BOSCH GMBH, 70442 Stuttgart (DE)
(72) Erfinder: Cuntz, Harald, Dr., 71296 Heimsheim (DE); Jares, Peter, 71069 Sindelfingen (DE); Karr, Dieter, 75233 Tiefenbronn (DE)

(56) Entgegenhaltungen:
- DE-A- 2 528 000
- DE-A- 19 509 786
- DE-A- 19 528 632

## Beschreibung

Die Erfindung betrifft ein Steuergerät umfassend wenigstens zwei Gehäuseteile und eine zwischen deren Randbereichen eingespannt befestigte, mit wenigstens einem Leistungsbauelement bestückte und eine wärmeleitende Schicht aufweisende Leiterplatte.

Ein derartiges Steuergerät geht beispielsweise aus der DE 195 28 632 A1 hervor. Bei diesem Steuergerät ist die wärmeleitende Schicht ein Füllstoff mit thermisch gut leitenden Eigenschaften, die sowohl an der Leiterplatte als auch an dem Gehäuseteil, auf dessen Randbereich sie aufliegt, haftet. Die Schicht ist vorzugsweise ein Klebstoff, durch den eine Verbindung zwischen der Leiterplatte und dem Gehäuseteil, auf dem sie aufliegt, hergestellt wird. Problematisch bei einem derartigen Steuergerät ist es, daß durch die Aufbringung der Klebeschicht eine spätere Demontage der Leiterplatte mit erheblichem Aufwand verbunden oder sogar unmöglich ist und die Gefahr einer Beschädigung der Leiterplatte in sich birgt.

Der Erfindung liegt daher die Aufgabe zugrunde, ein Steuergerät der gattungsgemäßen Art derart weiterzubilden, daß die Leiterplatte in dem Gehäuse unter Ausbildung eines möglichst kleinen thermischen Übergangswiderstands auf einfache Weise montiert und darüber hinaus auch wieder demontiert werden kann.

### Vorteile der Erfindung

Diese Aufgabe wird bei einem Steuergerät der eingangs beschriebenen Art erfindungsgemäß dadurch gelöst, daß die wärmeleitende Schicht eine an der Leiterplatte befestigte Kupferschicht ist, die mit einer Lötstoppschicht überdeckt ist, in der wenigstens dort, wo sie auf dem ihr gegenüberliegenden Gehäuseteil aufliegt, eine Mehrzahl von voneinander getrennt rasterförmig angeordneten, wärmeleitenden Kontaktelementen ausgebildet ist.

Die Ausbildung der wärmeleitenden Schicht als Kupferschicht hat den besonders großen Vorteil, daß sich aufgrund der hohen thermischen Leitfähigkeit von Kupfer nur ein geringer thermischer Übergangswiderstands zwischen der Leiterplatte und dem Gehäuse ausbildet. Dieser wird lediglich durch die Lötstoppschicht, die verhindert, daß die Kupferschicht beim Löten, insbesondere beim Wellenlöten, undefiniert mit Zinn überdeckt wird, erhöht.

Die Anordnung einer Mehrzahl von voneinander getrennten rasterförmig angeordneten, wärmeleitenden Kontaktelementen hat den besonders großen Vorteil, daß durch sie bei der Montage der Leiterplatte in dem Gehäuse ein direkter thermischer Kontakt zwischen der Kupferschicht und dem ihr gegenüberliegenden Gehäuseteil, d.h. eine Überbrückung der Lötstoppschicht, ermöglicht wird. Hierdurch wird der im wesentlichen durch die Lötstoppschicht bestimmte thermische Widerstand erheblich reduziert und gleichzeitig ein undefinierter Auftrag von Lötzinn verhindert.

Hinsichtlich der Ausbildung der wärmeleitenden Kontaktelemente in der Lötstoppschicht sind die unterschiedlichsten Ausführungsformen denkbar.

Eine besonders vorteilhafte Ausführungsform sieht vor, daß die Kontaktelemente in der Lötstoppschicht vorgesehene, mit Zinn gefüllte Öffnungen sind. Eine derartige Ausbildung der Kontaktelemente ermöglicht insbesondere ein sehr einfaches und kostengünstiges Herstellungsverfahren dadurch, daß beim Aufdrucken der Lötstoppschicht eine entsprechend ausgebildete Maske verwendet wird, in welcher die voneinander getrennten rasterförmig angeordneten Öffnungen vorgesehen sind. Das Auffüllen der Öffnungen mit Zinn geschieht anschließend durch HAL (Hot Air Leveling) und durch Wellenlöten zusammen mit der Herstellung der Lötverbindungen der Leiterplatte.

Hinsichtlich der Ausbildung der Kontaktelemente sind ebenfalls die unterschiedlichsten Ausführungsformen denkbar. Eine vorteilhafte Ausführungsform sieht vor, daß die Kontaktelemente jeweils eine kreisförmige Grundfläche aufweisen.

Bei einer anderen vorteilhaften Ausführungform ist vorgesehen, daß die Kontaktelemente jeweils eine polygonale Grundfläche aufweisen.

Die Kontaktelemente können beispielsweise eine rautenförmige Grundfläche aufweisen.

Sämtliche der oben beschriebenen Grundflächen ermöglichen bei Ausbildung der Kontaktelemente als mit Zinn gefüllte Öffnungen in der Lötstoppschicht eine besonders gute Benetzbarkeit mit Lötzinn.

### Zeichnung

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: im Schnitt schematisch ein erfindungsgemäßes Steuergerät;
- Fig. 2: schematisch ein erstes Ausführungsbeispiel von Kontaktelementen, die bei dem in Fig. 1 dargestellten erfindungsgemäßen Steuergerät zum Einsatz kommen und
- Fig. 3: schematisch eine andere Ausführungsform von Kontaktelementen, die bei dem in Fig. 1 dargestellten erfindungsgemäßen Steuergerät zum Einsatz kommen.

### Beschreibung der Ausführungsbeispiele

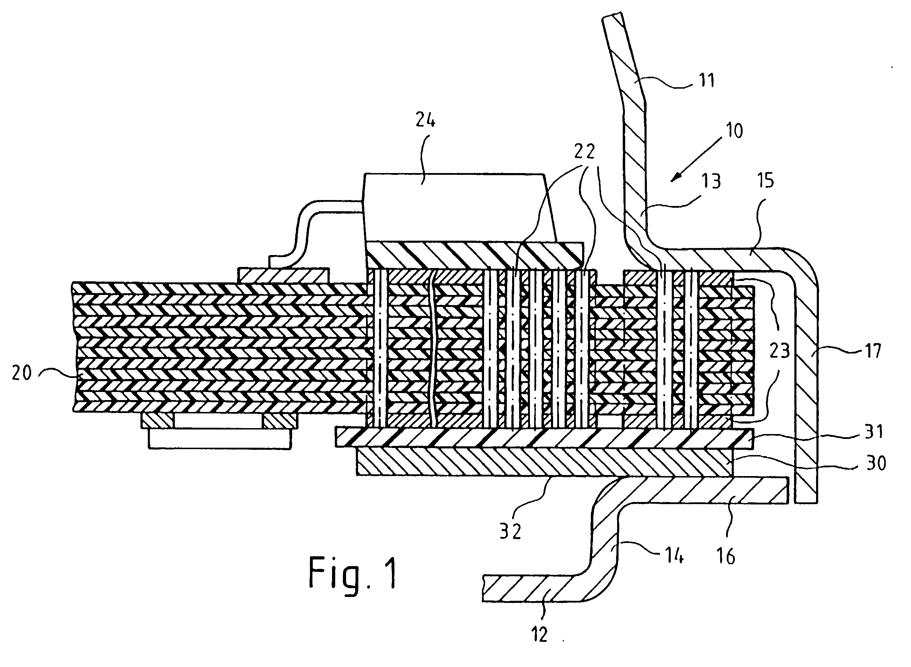

Ein Ausführungsbeispiel eines Steuergeräts, dargestellt in Fig. 1, umfaßt ein als Ganzes mit 10 bezeichnetes Gehäuse, welches zwei Gehäuseteile 11, 12 aufweist. In dem Gehäuse 10 ist eine an sich bekannte Leiterplatte 20 befestigt, auf deren Oberseite eine elektronische Schaltung angeordnet ist, von der nur ein Bauelement 24, welches im Betrieb Verlustwärme abgibt, dargestellt ist. Das Bauelement 24 ist, wie beispielsweise in Fig. 1 dargestellt, als SMD-Bauelement (Surface Mounted Device) auf der Leiterplatte 20 befestigt. Die Leiterplatte 20 ist auf an sich bekannte Weise mit einer (nicht dargestellten) Steckerleiste verbunden.

Die Oberseite der Leiterplatte 20 wird von einem deckelförmigen Gehäuseteil 11 überdeckt. Das Gehäuseteil 11 hat an seinem Randbereich 13 einen bis auf den Bereich der Steckerleiste durchgehenden, kragenförmigen Rand 15, der eine abgewinkelte Kante 17 umfaßt. Diese Kante 17 kann bündig mit der Unterseite der untersten, auf der Leiterplatte 20 angeordneten Schicht abschließen, oder über diese hinausragen, wie es in Fig. 1 dargestellt ist.

Die Unterseite der Leiterplatte 20 wird von einem als wannenförmiger Gehäuseboden ausgebildeten Gehäuseteil 12 überdeckt, dessen Seitenwände 14 ebenfalls einen kragenförmigen Rand 16 aufweisen, der in seinem Randbereich auf der Unterseite der Leiterplatte und sämtlichen auf ihr angeordneten Schichten anliegt. Auf der Ober- und Unterseite der Leiterplatte 20 ist wenigstens im Bereich der Leistungsbauelemente 24 und dort, wo die Leiterplatte an dem oberen bzw. unteren Gehäuseteil 11, 12 anliegt, eine Kupferschicht 23 aufgebracht. In der Leiterplatte 20 sind Durchkontaktierungen 22 vorgesehen, welche die Kupferschichten 23 thermisch miteinander verbinden. Auf der Unterseite der Leiterplatte 20 unter der dort teilweise aufgebrachten Kupferschicht 23 ist über eine an sich bekannte prepreg-Schicht 31 eine Kupferschicht 30 befestigt, die an ihrer dem Gehäuseteil 11 zugewandten Seite mit einer Lötstoppschicht 32 überdeckt ist.

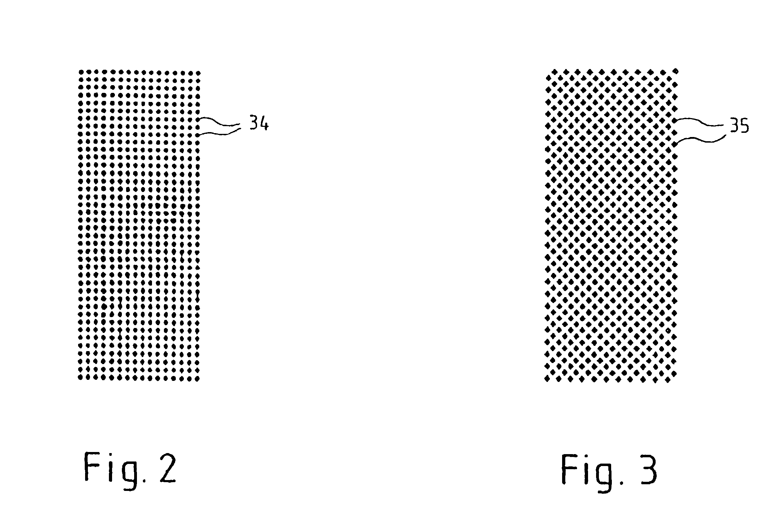

In der Lötstoppschicht 32 ist eine Mehrzahl von voneinander getrennt rasterförmig angeordneten wärmeleitenden Kontaktelementen 34, 35 ausgebildet. Diese können beispielsweise, wie in Fig. 2 dargestellt, eine kreisförmige Grundfläche oder, wie in Fig. 3 dargestellt, eine rautenförmige Grundfläche aufweisen.

Die Kontaktelemente 34, 35 werden auf einfache Weise dadurch hergestellt, daß die Lötstoppschicht 32 über eine Maske auf die Kupferschicht 30, beispielsweise durch einen Siebdruckvorgang aufgebracht wird, in welcher für den Lötstopplack der Lötstoppschicht undurchlässige Bereiche vorgesehen sind, welche jeweils die Gestalt der Grundflächen der Kontaktelemente 34, 35 aufweisen und ein Aufbringen der Lötstoppschicht 32 auf die Kupferschicht 30 verhindern. Bei einem späteren HAL und Wellenlötvorgang werden die auf diese Weise in der Lötstoppschicht 32 ausgesparten Flächen der Kupferschicht 30 mit Lötzinn überdeckt und dadurch die Öffnungen in der Lötstoppschicht mit Zinn gefüllt.

Durch die Kontaktelemente 34, 35 wird auf einfache Weise ein definierter thermisch leitfähiger Übergang zwischen der Kupferschicht 30 und dem Gehäuseteil 11 hergestellt und hierdurch der verhältnismäßig hohe thermische Übergangswiderstand der Lötstoppschicht 32 reduziert und dadurch das thermische Verhalten der gesamten Steuerschaltung verbessert.

Die prepreg-Schicht 31 und die Kupferschicht 30 können auch fehlen. Die Kontaktelemente 34, 35 sitzen dann direkt in der Lötstoppschicht 32 der unteren Kupferschicht 23.

Die Leiterplatte 20 ist mit sämtlichen auf ihr aufgebrachten Schichten 23, 31, 30, 32 durch eine Klemmbefestigung zwischen dem Gehäuseteil 12 und dem Gehäuseteil 11 an dem Gehäuse 10 befestigt (Fig. 1). Durch diese Klemmbefestigung wird die obenbeschriebene besonders gute Ableitung der von den Leistungsbauelementen 24 erzeugten Verlustwärme unterstützt, da hierdurch ein sehr guter Kontakt zwischen den Kontaktelementen 34, 35 und dem Gehäuseteil 12 auf dem sie aufliegen und damit eine gute Ableitung der Verlustwärme auf das Gehäuse ermöglicht wird.

## Patentansprüche

1. Steuergerät, umfassend wenigstens zwei Gehäuseteile (11, 12) und eine zwischen deren Randbereichen (14, 15) z.B. durch eine Klemmbefessigung nur eingespannt befestigte, mit wenigstens einem Leistungsbauelement (24) bestückte und eine wärmeleitende Schicht aufweisende Leiterplatte (20), **dadurch gekennzeichnet, daß** die wärmeleitende Schicht eine an der Leiterplatte befestigte Kupferschicht (23', 30) ist, die mit einer Lötstoppschicht (32) überdeckt ist, in der wenigstens dort, wo sie auf dem ihr gegenüberliegenden Gehäuseteil (12) aufliegt, eine Mehrzahl von voneinander getrennt rasterförmig angeordneten, wärmeleitenden Kontaktelementen (34, 35) ausgebildet sind.

2. Steuergerät nach Anspruch 1, **dadurch gekennzeichnet, daß** die Kontaktelemente in der Lötstoppschicht (32) vorgesehene, mit Zinn gefüllte Öffnungen sind.

3. Steuergerät nach Anspruch 1 oder 2, **dadurch gekennzeichnet, daß** die Kontaktelemente (34) jeweils eine kreisförmige Grundfläche aufweisen.

4. Steuergerät nach Anspruch 1 oder 2, **dadurch gekennzeichnet, daß** die Kontaktelemente jeweils eine polygonale Grundfläche aufweisen.

5. Steuergerät nach Anspruch 4, **dadurch gekennzeichnet, daß** die Kontaktelemente jeweils eine rautenförmige Grundfläche aufweisen.

## Claims

1. Control device, comprising at least two housing parts (11, 12) and a printed circuit board (20) fastened between the edge regions (14, 15) of the latter, for example only clamped in by a clamping type of fastening, the printed circuit board being fitted with at least one power component (24) and having a thermally conducting layer, **characterized in that** the thermally conducting layer is a copper layer (23, 30), which is fastened to the printed circuit board and is covered by a solder stop layer (32), in which there are formed, at least where it rests on the housing part (12) lying opposite it, a plurality of thermally conducting contact elements (34, 35), which are separate from one another and arranged in the form of a matrix.

2. Control device according to Claim 1, **characterized in that** the contact elements are openings provided in the solder stop layer (32) and filled with tin.

3. Control device according to Claim 1 or 2, **characterized in that** the contact elements (34) in each case have a circular base area.

4. Control device according to Claim 1 or 2, **characterized in that** the contact elements in each case have a polygonal base area.

5. Control device according to Claim 4, **characterized in that** the contact elements in each case have a rhombic base area.

## Revendications

1. Appareil de commande comprenant au moins deux éléments de boîtier (11, 12) et une plaquette fixée entre leurs éléments de bord (14, 15) (par exemple en étant simplement encastrée au moyen d'une fixation de serrage), équipée d'au moins un composant de puissance (24) et comportant une couche thermoconductrice (20),
**caractérisé en ce que**
la couche thermoconductrice est une couche de cuivre (23, 30) fixée sur la plaquette et recouverte d'une couche d'arrêt de brasage (32) dans laquelle, au moins là où elle s'appuie sur l'élément de boîtier (12) qui lui fait face, est formée une multiplicité d'éléments de contact thermo-conducteurs (34, 35), disposés en forme de réseau séparés les uns des autres.

2. Appareil de commande selon la revendication 1,
**caractérisé en ce que**
les éléments de contact sont des ouvertures pratiquées dans la couche d'arrêt de brasage (32) et remplies d'étain.

3. Appareil de commande selon la revendication 1 ou 2,
**caractérisé en ce que**
les éléments de contact (34) présentent à chaque fois une surface de base circulaire.

4. Appareil de commande selon la revendication 1 ou 2,
**caractérisé en ce que**
les éléments de contact présentent à chaque fois une surface de base polygonale.

5. Appareil de commande selon la revendication 4,
**caractérisé en ce que**
les éléments de contact présentent à chaque fois une surface de base en forme de losange.
